(19) Europäisches Patentamt / European Patent Office / Office européen des brevets

(11) **EP 2 908 214 A1**

(12) **EUROPEAN PATENT APPLICATION**
published in accordance with Art. 153(4) EPC

(43) Date of publication:
**19.08.2015 Bulletin 2015/34**

(51) Int Cl.:
***G06F 3/01*** *(2006.01)*    ***G06F 3/042*** *(2006.01)*

(21) Application number: **12886868.4**

(22) Date of filing: **06.12.2012**

(86) International application number:
**PCT/CN2012/086007**

(87) International publication number:
**WO 2014/059731 (24.04.2014 Gazette 2014/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.10.2012 CN 201210389018**

(71) Applicants:
• **Shenzhen Skyworth Digital Technology Co. Ltd.**
Shenzhen, Guangdong 518000 (CN)
• **Shenzhen Skyworth Software Co. Ltd.**
Shenzhen, Guangdong 518057 (CN)

(72) Inventors:
• **WANG, Xiaohui**
Shenzhen
Guangdong 518000 (CN)

• **MAO, Guohong**
Shenzhen
Guangdong 518000 (CN)
• **WEN, Lifu**
Shenzhen
Guangdong 518000 (CN)
• **SHI, Chi**
Shenzhen, Guangdong 518000 (CN)

(74) Representative: **Johnson, Richard Alan et al**
**Mewburn Ellis LLP**
**City Tower**
**40 Basinghall Street**
**London EC2V 5DE (GB)**

(54) **METHOD, DEVICE AND SYSTEM FOR LIGHT REMOTE CONTROL POSITIONING**

(57)    A method a device and a system for light remote control positing. Position coordinates of a light beam spot can be obtained by a sensing film, so that remote control of interface elements can be realized. The method comprises the following steps: sensing, by means of a light sensing film covered on a display screen of a receiving terminal device, a light beam spot formed on the light sensing film by a light beam that is emitted by a transmitting terminal device (S101); and extracting position parameters of the light beam spot on the light sensing film, which are sensed by the light sensing film, and calculating out the position coordinates of the light beam spot based on the position parameter (S102).

```
┌─────────────────────────────────────┐
│ Sensing, by means of a light sensing │ ╱ S101
│ film covered on a display screen of a│╱
│ receiving terminal device, a light   │
│ beam spot formed on the light sensing│
│ film by a light beam that is         │
│ emitting by a transmitting terminal  │
│ device                               │
└─────────────────────────────────────┘
                    │
                    ▼
┌─────────────────────────────────────┐
│ Extracting position parameters of the│ ╱ S102
│ light beam spot on the light sensing │╱
│ film, which are sensed by the light  │
│ sensing film, and calculating out a  │
│ position coordinates of the light    │
│ beam spot based on the position      │
│ coordinates                          │
└─────────────────────────────────────┘
```

**FIG. 1**

EP 2 908 214 A1

**Description**

TECHNICAL FIELD

The present disclosure relates to the field of electronic technologies, and more particularly to a method, a device and a system for light remote control positioning.

BACKGROUND

Remote control is a device for remotely controlling other controlled devices. Ordinarily, an infrared remote control mainly includes an integrated circuit board and buttons for generating different signals. The infrared remote control has the advantage of being simply and easy used. However, with the development of the electronic technology, the functions of some controlled devices are more and more complicated. For example, a current television may have the functions of browsing webpage, playing dynamic games, and have more and more interface elements. Thus, the traditional remote control cannot satisfy new operating requirements. Moreover, the traditional infrared remote control does not provide a positioning function itself. Actually, the positioning function of the infrared remote control can be realized by mobile information generated by an operation of any button on the infrared remote control so as to changing a positioning. A relative position between the remote control and a screen of the television cannot be displayed, thereby bringing inconvenience for the user, and reducing the experience of the user.

SUMMARY

In order to solve the above-mentioned problems existing in the existing technology, a method, a device and a system for light remote control positioning are provided, which can obtain position coordinates of a light beam spot by means of a light sensing file, so as to realize remote control of interface elements. Technical proposals are described as follows.
In order to solve the problem described above, a method for light remote control positioning is provided in an embodiment of present disclosure. The method for light remote control positioning including:

sensing, by means of a light sensing film covered on a display screen of a receiving terminal device, a light beam spot formed on the light sensing film by a light beam that is emitting by a transmitting terminal device; and
extracting position parameters of the light beam spot on the light sensing film, which are sensed by the light sensing film, and calculating out position coordinates of the light beam spot based on the position coordinates.
wherein the step of extracting position parameters of the light beam spot on the light sensing film, which are sensed by the light sensing film, and calculating out position coordinates of the light beam spot based on the position coordinates includes:
extracting a horizontal axis resistance value and a vertical axis resistance value of the light beam spot on the light sensing film sensed by the light sensing film;
calculating out a position coordinate of the light beam spot relative to the light sensing film according to the horizontal axis resistance value of the light beam spot and the vertical axis resistance value of the light beam spot of the light beam spot.
wherein the step of calculating out a position coordinate of the light beam spot relative to the light sensing film according to the horizontal axis resistance value of the light beam spot and the vertical axis resistance value of the light beam spot of the light beam spot includes:
presetting a full screen horizontal axis resistance value and a full screen vertical axis resistance value of the light sensing film, and a horizontal axis length and a vertical axis length of the light sensing film;
calculating out the ratio of the horizontal axis resistance value of the light beam spot to the full screen horizontal axis resistance value and obtaining a horizontal axis coordinate of the light beam spot by multiplying the ratio by the horizontal axis length of the light sensing film;
calculating out the ratio of the vertical axis resistance value of the light beam spot to the full screen vertical axis resistance value, and obtaining a vertical axis coordinate of the light beam spot by multiplying the ratio by the vertical axis length of the light sensing film.
wherein after the step of extracting a horizontal axis resistance value of the light beam spot and a vertical axis resistance value of the light beam spot of the light beam spot on the light sensing film sensed by the light sensing film, the method further includes:
receiving keystroke information transmitted by the transmitting terminal device;
performing operations of the light beam spot on the position coordinates according to the keystroke information and the position coordinates.

wherein the light sensing film includes three layers and the three layers are a first layer, a second layer and a third layer, the first layer is a resistive layer with uniform resistance, the second layer is a photoconductive layer with a photosensitive characteristic, the third layer is a conductive layer, when the photoconductive layer is irradiated by the light beam, the photoconductive layer is connected to the resistive layer and the conductive layer to let the light sensing film sense the position of light beam spot, the receiving terminal device extracts the position parameters of the light beam spot on the light sensing film according to the resistance value of the resistive layer.

wherein when the light beam emitted by a transmitting terminal device is the visible light, the light sensing film directly senses a position on which the light beam spot formed by the visible light is projected on the light sensing film.

wherein when the light beam emitted by a transmitting terminal device is the invisible light, a display screen generates a cursor pattern on the position on which the light beam of the invisible light is projected on the light sensing film.

wherein when the light beam emitted by a transmitting terminal device is the mixed light beam of visible light and invisible light, the light sensing film directly senses a position on which the light beam spot formed by the mixed light beam spot is projected on the light sensing film.

Accordingly, a device for light remote control positioning is provided in an embodiment of present disclosure. The device for light remote control positioning includes:

a sensing module configured to sense, by means of a light sensing film covered on a display screen of a receiving terminal device, a light beam spot formed on the light sensing film by a light beam that is emitting by a transmitting terminal device; and
an extracting and calculating module configured to extract position parameters of the light beam spot on the light sensing film, which are sensed by the light sensing film, and calculate out position coordinates of the light beam spot based on the position coordinates.
wherein the extracting and calculating module includes:
an extracting sub-module configured to extract a horizontal axis resistance value of the light beam spot and a vertical axis resistance value of the light beam spot of the light beam spot on the light sensing film sensed by the light sensing film;
a calculating sub-module configured to calculate out a position coordinate of the light beam spot relative to the light sensing film according to the horizontal axis resistance value of the light beam spot and the vertical axis resistance value of the light beam spot of the light beam spot.
wherein the calculating sub-module includes:
a preset sub-module configured to preset a full screen horizontal axis resistance value of the light sensing film, a full screen vertical axis resistance value of the light sensing film, a horizontal axis length of the light sensing film, and a vertical axis length of the light sensing film;
a horizontal axis coordinate calculating sub-module configured to obtain a horizontal axis coordinate of the light beam spot by calculating out a ratio of the horizontal axis resistance value of the light beam spot and the full screen horizontal axis resistance value, and multiplying the ratio by the horizontal axis length of he light sensing film;
a vertical axis coordinate calculating sub-module configured to obtain a vertical axis coordinate of the light beam spot by calculating out a ratio of the vertical resistance value of the light beam spot and the full screen vertical axis resistance value, and multiplying the ratio by the vertical axis length of the light sensing film.
the device for light remote control positioning further includes:
a receiving module configured to receive keystroke information transmitted by the transmitting terminal device;
a performing module is configured to perform operations of the light beam spot on the position coordinates of the light beam spot according to the keystroke information and the position coordinates.
wherein the light sensing film includes three layers and the three layers are a first layer, a second layer and a third layer, the first layer is a resistive layer with uniform resistance, and the second layer is a photoconductive layer with a photosensitive characteristic, the third layer is a conductive layer, when the photoconductive layer is irradiated by the light beam, the photoconductive layer is connected the resistive layer and the conductive layer to let the light sensing film sense the position of light beam spot, the receiving terminal device extracts the position parameters of the light beam spot on the light sensing film according to the resistance value of the resistive layer.
wherein when the light beam emitted by a transmitting terminal device is visible light, the light sensing film directly senses the light beam spot formed by the visible light on the light sensing film.
wherein when the light beam emitted by a transmitting terminal device is the invisible light, a display screen generates a cursor pattern on the position on which the light beam of the invisible light is projected on the light sensing film.
wherein when the light beam emitted by a transmitting terminal device is the mixed light beam of visible light and invisible light, the light sensing film directly senses a position on which the light beam spot formed by the mixed light beam spot is projected on the light sensing film.

Accordingly, a system for light remote control positioning is provided in an embodiment of present disclosure. The system for light remote control positioning includes a transmitting terminal device and a receiving device described above;

the transmitting terminal device configured to transmit light beam to a display screen of the receiving terminal device to form a light beam spot, and transmit keystroke information to the receiving terminal device when a button is operated.

A beneficial effect of the embodiments of present disclosure is described as follows.

In the embodiment of present disclosure, the light beam is emitted by the transmitting terminal device, the light beam spot formed on the light sensing film by the light beam is sensed by the light sensing film; the position parameters of the light beam spot on the light sensing film are extracted, and the position coordinates of the light beam spot are figured out according to the position parameters. The light beam spot points to the interface elements which need to be operated, therefore, an accurate remote control operation to the interface elements is realized for the user, and the user experience is improved.

BRIEF DESCRIPTION OF THE DRAWINGS

In order to make embodiments of present disclosure more clearly, the drawings which are needed in the embodiments of present disclosure are described simply as follows. It is obviously, the drawings described as the follows are only exemplary embodiments of present disclosure. To a person of ordinary skill in the art, under premise of no creative work, other drawings may be obtained according to the drawings.

FIG. 1 is a flowchart of a method for light remote control positioning according to one embodiment of present disclosure;

FIG. 2 is a flowchart of a method for light remote control positioning according to another embodiment of present disclosure;

FIG. 3 is a schematic diagram of a system for light remote control positioning according to an embodiment of present disclosure;

FIG. 4 is a schematic diagram of a receiving terminal device according to an embodiment of present disclosure;

FIG. 5 is a schematic diagram of an extracting and calculating module of FIG. 4 according to an embodiment of present disclosure; and

FIG. 6 is a schematic diagram of a calculating sub-module of FIG. 5 according to an embodiment of present disclosure.

DETAILED DESCRIPTION OF ILLUSTRATED EMBODIMENTS

In order to make embodiments of present disclosure more clearly, the drawings which are needed in the embodiments of present disclosure are described simply as follows. It is obviously, the drawings described as the follows are only exemplary embodiments of present disclosure. To a person of ordinary skill in the art, under premise of no creative work, other drawings may be obtained according to the drawings. Based on the embodiments of the present disclosure, under the premise of no creative work, other embodiments obtained by the person with ordinary skills in the art are belong to a protection scope of the present disclosure.

A method, a device and a system for light remote control positioning are provided in the embodiments of present disclosure. Position coordinates of a light beam spot can be obtained by a sensing film, so that remote control of interface elements can be realized. Detail descriptions will be illustrated with the embodiment as follows.

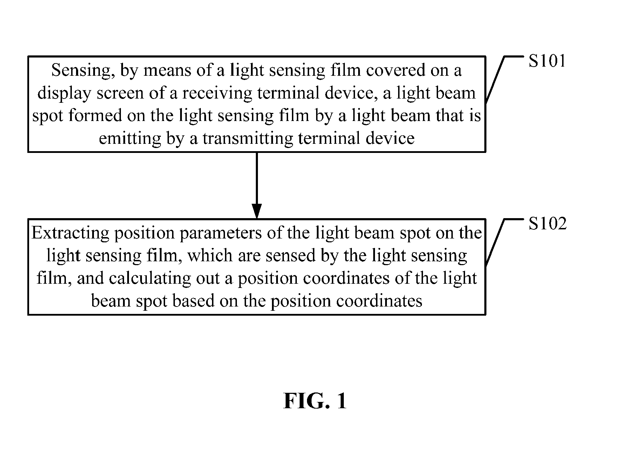

Referring to FIG. 1, FIG. 1 is a flowchart of a method for light remote control positioning according to one embodiment of present disclosure. As shown in FIG. 1, the method for light remote control positioning includes the following steps.

Step S101, sensing, by means of a light sensing film covered on a display screen of a receiving terminal device, a light beam spot formed on the light sensing film by a light beam that is emitting by a transmitting terminal device..

In detail, the light beam emitted by the transmitting terminal device can be visible light, or invisible light, or a mixed light beam of the visible light and the invisible light. The light beam emitted by the transmitting terminal device can be light which can not be emitted by the display screen, such as ultraviolet light.

When the light beam emitted by the transmitting terminal device is the visible light, the light sensing film directly senses a position of the light beam. When the user moves a remote control, the light beam spot projected on the display screen and the light beam move with the remote control. The user can operate the interface elements by the light beam spot formed by the light beam of the visible light.

When the light beam emitted by the transmitting terminal device is the invisible light, the invisible light has certain intensity, and the invisible light can be infrared light or ultraviolet light. The light sensing film senses a position on which the light beam of the invisible light is projected, the display screen of the receiving terminal device displays a pattern such as a cursor pattern on the position on which the light beam of the invisible light is projected. If the user moves the remote control, the light beam spot projected on the display screen and the light beam move with the remote control. At the same time, the receiving terminal device instantly refreshes the cursor pattern on the display screen according to the position of the light beam spot sensed by the receiving terminal device, which is used for giving the user an instruction.

If the light beam emitted by the transmitting terminal device is the mixed light beam of the visible light and the invisible light, the visible light is configured to give the user an instruction and the invisible light is configured to let the light sensing film sense a position on which the mixed light beam is projected. The user moves the remote control, a mixed light beam spot projected on the display screen and the mixed light beam move with the remote control. The user can operate the interface elements through the mixed light beam spot formed by the mixed light beam.

Step S102, extracting position parameters of the light beam spot on the light sensing film, which are sensed by the light sensing film, and calculating out position coordinates of the light beam spot based on the position coordinates.

In detail, the light sensing film includes a conductive layer, a resistive layer having uniform resistance, and a photoconductive layer with a photosensitive characteristic. In other words, the light sensing film includes three layers and the three layers are a first layer, a second layer, and a third layer. The first layer is the resistive layer with uniform resistance, the resistance value of the first layer is constant and even-distributed. The second layer is the photoconductive layer with a photosensitive characteristic, and the characteristic of the second layer is that the resistance value of the second layer is great when there is no light beam, but the resistance value of the second layer drops rapidly to small once there is a light beam irradiating on the second layer. The third layer is a conductive layer whose resistance value is very small and can be almost omitted. When the photoconductive layer is irradiated by the light beam, the photoconductive layer is connected to the resistive layer and the conductive layer to let the light sensing film sense the position of light beam spot. The receiving terminal device extracts the position parameters of the light beam spot on the light sensing film according to the resistance value of the resistive layer. For example, when a light beam irradiates into a certain point of the first layer, supposing that the point where the light beam irradiates into on the first layer is a point A, and assuming that the point where the light beam irradiates in on the second layer is a point B, because the resistance value of the second layer drops rapidly to very small when the second layer is irradiated by the light beam, so that the resistance value of the point B drops rapidly to very small, which is almost equivalent that the point A of the first layer conducts with the third layer through the point B. At this point, the receiving terminal device extracts the resistance value of the point A, in other words, the receiving terminal device extracts the position parameters of the light beam spot on the light sensing film, and then the receiving terminal device calculates out the position coordinates of the light beam spot according to the position parameters in order to let the receiving terminal device position the interface elements according to the position coordinates.

In the embodiment of present disclosure, the light beam is emitted by the transmitting terminal device, the light beam spot formed on the light sensing film by the light beam is sensed by the light sensing film; the position parameters of the light beam spot on the light sensing film are extracted, and the position coordinates of the light beam spot are figured out according to the position parameters. The light beam spot points to the interface elements which need to be operated, therefore, an accurate remote control operation to the interface elements is realized for the user, and the user experience is improved.

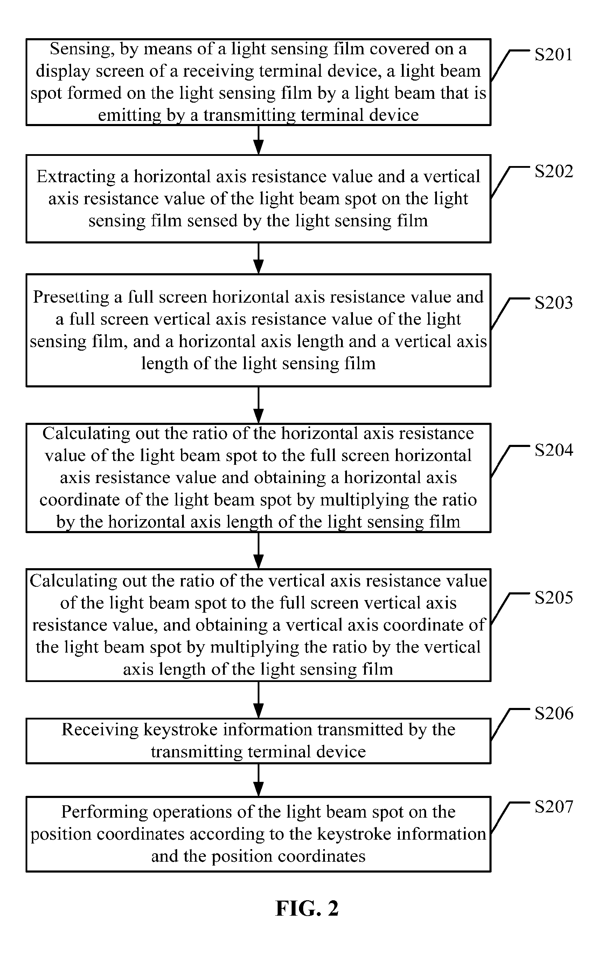

Referring to FIG. 2, FIG. 2 is a flowchart of a method for light remote control positioning according to another embodiment of present disclosure. As shown in FIG. 2, the method for light remote control positioning in the embodiment includes the following steps.

Step S201, sensing, by means of a light sensing film covered on a display screen of a receiving terminal device, a light beam spot formed on the light sensing film by a light beam that is emitting by a transmitting terminal device.

In detail, the light beam emitted by the transmitting terminal device can be visible light, or invisible light, or a mixed light beam of the visible light and the invisible light. The light beam emitted by the transmitting terminal device can be light which can not be emitted by the display screen, such as ultraviolet light.

When the light beam emitted by the transmitting terminal device is the visible light, the light sensing film directly senses a position of the light beam. When the user moves the remote control, the light beam spot projected on the display screen and the light beam move with the remote control. The user can operate the interface elements by the light beam spot formed by the light beam of the visible light.

When the light beam emitted by the transmitting terminal device is the invisible light, the invisible light has certain intensity, and the invisible light can be infrared light or ultraviolet light. The light sensing film senses a position on which the light beam of the invisible light is projected, the display screen of the receiving terminal device displays a pattern such as a cursor pattern on the position projected by the light beam of the invisible light. If the user moves the remote control, the light beam spot projected on the display screen and the light beam move with the remote control. At the same time, the receiving terminal device instantly refreshes the cursor pattern on the display screen according to the position of the light beam spot sensed by the receiving terminal device, which is used for giving the user an instruction.

If the light beam emitted by the transmitting terminal device is the mixed light beam of the visible light and the invisible light, the visible light is configured to give the user an instruction and the invisible light is configured to let the light sensing film sense a position on which the mixed light beam is projected. The user moves the remote control, a mixed light beam spot projected on the display screen and the mixed light beam move with the remote control. The user can operate the interface elements through the mixed light beam spot formed by the mixed light beam.

Step S202, extracting a horizontal axis resistance value and a vertical axis resistance value of the light beam spot on the light sensing film sensed by the light sensing film.

In detail, the light sensing film includes a conductive layer, a resistive layer having uniform resistance, and a photoconductive layer with a photosensitive characteristic. In other words, the light sensing film includes three layers, and the three layers are a first layer, a second layer, and a third layer. The first layer is the resistive layer with uniform resistance, the resistance value of the first layer is constant and even-distributed. The second layer is the photoconductive layer with a photosensitive characteristic, and the characteristic of the second layer is that the resistance value of the second layer is great when there is no light beam, but the resistance value of the second layer drops rapidly to small once there is a light beam irradiating on the second layer. The third layer is a conductive layer whose resistance value is very small and can be almost omitted. When the photoconductive layer is irradiated by the light beam, the photoconductive layer is connected to the resistive layer and the conductive layer to let the light sensing film sense the position of light beam spot. The receiving terminal device extracts the position parameters of the light beam spot on the light sensing film according to the resistance value of the resistive layer. For example, when a light beam irradiates into a certain point of the first layer, supposing that the point where the light beam irradiates into the first layer is a point A, and assuming that the point where the light beam irradiates in on the second layer is a point B, because the resistance value of the second layer drops rapidly to very small when the second layer is irradiated by the light beam, so that the resistance value of the point B drops rapidly to very small, which is almost equivalent that the point A of the first layer conducts with the third layer through the point B. At this point, the receiving terminal device extracts the resistance value of the point A, in other words, the receiving terminal device extracts the horizontal axis resistance value of the light beam spot and the vertical axis resistance value of the light beam spot.

Step S203, presetting a full screen horizontal axis resistance value and a full screen vertical axis resistance value of the light sensing film, and a horizontal axis length and a vertical axis length of the light sensing film.

In detail, each of the four sides of the first layer of the light sensing film has an electrode. The full screen horizontal axis resistance value is the resistance value between the left side electrode and the right side electrode of the first layer of the light sensing film, and the full screen horizontal axis resistance value is set to be R1. The full screen vertical axis resistance value is the resistance value between the top side electrode and the bottom side electrode of the first layer of the light sensing film, and the full screen vertical axis resistance value is set to be R2. The horizontal axis length of the light sensing film is set to be X, and the vertical axis length of the light sensing film is set to be Y.

Step S204, calculating out the ratio of the horizontal axis resistance value of the light beam spot to the full screen horizontal axis resistance value and obtaining a horizontal axis coordinate of the light beam spot by multiplying the ratio by the horizontal axis length of the light sensing film.

In detail, assuming that the light beam spot is P, when the light sensing film is irradiated by light, the light beam spot P on the first layer is connected to the electrodes of the third layer. The horizontal axis resistance value and the vertical axis resistance value of the light beam spot of the light beam spot P which is between the electrodes of the first layer and the electrodes of the third layer are calculated out by the receiving terminal device. Assuming that the horizontal axis resistance value of the light beam spot is R3 and the horizontal axis coordinate of the light beam spot P is Xp, and then the horizontal axis coordinate Xp is calculated out according to a formula 1 as follows:

$$Xp = X*(R3/R1) \tag{1}$$

Step S205, calculating out the ratio of the vertical axis resistance value of the light beam spot to the full screen vertical axis resistance value, and obtaining a vertical axis coordinate of the light beam spot by multiplying the ratio by the vertical axis length of the light sensing film.

In detail, assuming that the vertical axis resistance value of the light beam spot is R4 and the vertical axis coordinate of the light beam spot P is Yp, and then the vertical axis coordinate Yp is calculated out according to a formula 2 as follows.

$$Yp = Y*(R4/R2) \tag{2}$$

The interface elements which need to be operated are accurately positioned by accurately calculating the position coordinates of the light beam spot.

Step S206, receiving keystroke information transmitted by the transmitting terminal device.

In detail, the receiving terminal device can receives the keystroke information transmitted by the transmitting terminal device through the infrared or other wireless manners.

Step S207, performing operations of the light beam spot on the position coordinates according to the keystroke information and the position coordinates.

In detail, when the receiving terminal device receives the keystroke information, then the receiving terminal device performs a series of operations of the light beam spot corresponding to the interface elements on the position coordinates. For example, when a light beam spot of the light beam moves to a HTTP webpage link, the receiving terminal device obtains the position of the light beam spot through the light sensing film. When the button of the remote control is operated, the terminal such as a television is controlled to perform an operation of opening the webpage link on the position of the light beam spot.

In the embodiment of present disclosure, the light beam is emitted by the transmitting terminal device, the light beam spot formed on the light sensing film by the light beam is sensed by the light sensing film; the position parameters of the light beam spot on the light sensing film are extracted, and the position coordinates of the light beam spot are figured out according to the position parameters. The light beam spot points to the interface elements which are need to be operated, therefore, an accurate remote control operation to the interface elements is realized for the user, and the user experience of the user is improved.

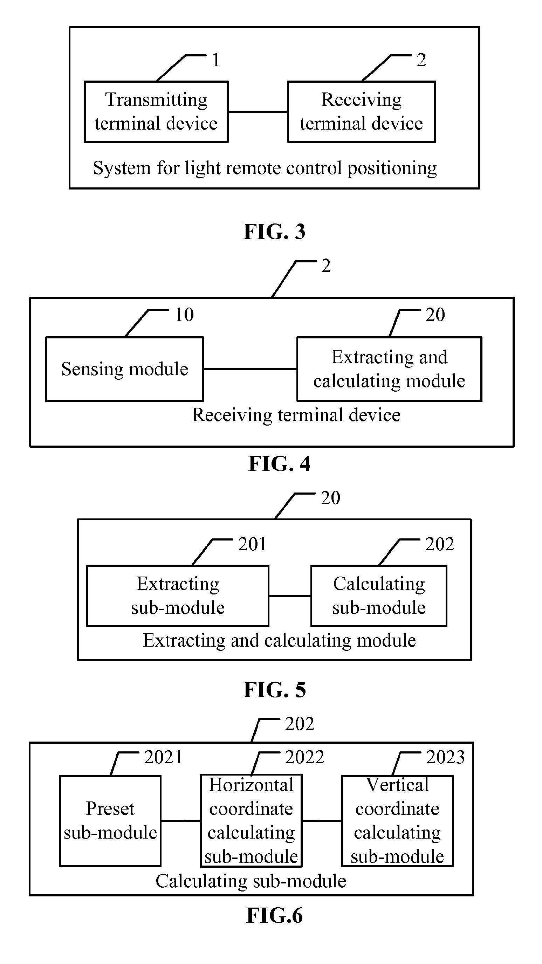

Referring to FIG. 3, FIG. 3 is a schematic diagram of a system for light remote control positioning according to an embodiment of present disclosure. The system for light remote control positioning includes a transmitting terminal device 1 and a receiving terminal device 2.

The transmitting terminal device 1 is configured to transmit light beam to a display screen of the receiving terminal device to form a light beam spot, and transmit keystroke information to the receiving terminal device when a button is operated.

In detail, the light beam emitted by the transmitting terminal device can be visible light, or invisible light, or a mixed light beam of the visible light and the invisible light. The light beam emitted by the transmitting terminal device can be light which can not be emitted by the display screen, such as ultraviolet light. When the user operates the button, the transmitting terminal device 1 transmits the keystroke information to the receiving terminal device 2 through infrared or other wireless manners.

The receiving terminal device 2 is configured to sense, by means of a light sensing film covered on a display screen of a receiving terminal device, a light beam spot formed on the light sensing film by a light beam that is emitted by a transmitting terminal device, and extract position parameters of the light beam spot on the light sensing film, which are sensed by the light sensing film, and calculate out position coordinates of the light beam spot based on the position coordinates.

In detail, when the light beam emitted by the transmitting terminal device is the visible light, the light sensing film directly senses a position of the light beam. When the user moves a remote control, the light beam spot projected on the display screen and the light beam move with the remote control. The user can operate the interface elements by the light beam spot formed by the light beam of the visible light.

When the light beam emitted by the transmitting terminal device is the invisible light, the invisible light has certain intensity, and the invisible light can be infrared light or ultraviolet light. The light sensing film senses a position on which the light beam of the invisible light is projected, the display screen of the receiving terminal device displays a pattern such as a cursor pattern on the position on which the light beam of the invisible light is projected. If the user moves the remote control, the light beam spot projected on the display screen and the light beam move with the remote control. At the same time, the receiving terminal device instantly refreshes the cursor pattern on the display screen according to the position of the light beam spot sensed by the receiving terminal device, which is used for giving the user an instruction.

If the light beam emitted by the transmitting terminal device is the mixed light beam of the visible light and the invisible light, the visible light is configured to give the user an instruction and the invisible light is configured to let the light sensing film sense a position on which the mixed light beam is projected. The user moves the remote control, a mixed light beam spot projected on the display screen and the mixed light beam move with the remote control. The user can operate the interface elements through the mixed light beam spot formed by the mixed light beam.

The light sensing film includes a conductive layer, a resistive layer having uniform resistance, and a photoconductive layer with a photosensitive characteristic. In other words, the light sensing film includes three layers, and the three layers are a first layer, a second layer, and a third layer. The first layer is the resistive layer with uniform resistance, the resistance value of the first layer is constant and even-distributed. The second layer is the photoconductive layer with a photosensitive characteristic, and the characteristic of the second layer is that the resistance value of the second layer is great when there is no light beam, but the resistance value of the second layer drops rapidly to small once there is a light beam irradiating on the second layer. The third layer is a conductive layer whose resistance value is very small and can be almost omitted. When the photoconductive layer is irradiated by the light beam, the photoconductive layer is connected to the resistive layer and the conductive layer to let the light sensing film sense the position of light beam spot. The receiving terminal device extracts the position parameters of the light beam spot on the light sensing film according to the resistance value of the resistive layer. For example, when a light beam irradiates into a certain point of the first layer, supposing that the point where the light beam irradiates into on the first layer is a point A, and assuming that the point where the light beam irradiates in on the second layer is a point B, because the resistance value of the second layer drops rapidly to very small when the second layer is irradiated by the light beam, so that the resistance value of the point B drops rapidly to very small, which is almost equivalent that the point A of the first layer conducts with the third layer through the point B with a very small resistance value of the second layer. At this point, the receiving terminal device extracts the resistance value of the point A, in other words, the receiving terminal device extracts the position parameters of the light beam spot on the light sensing film, and then the receiving terminal device calculates out the position coordinates of the light beam spot according to the position parameters in order to let the receiving terminal device position the interface elements according to the position coordinates.

The receiving terminal device 2 is further configured to receive keystroke information transmitted by the transmitting terminal device and perform operation of the position coordinate of the light beam spot according to the keystroke information and the position coordinate.

Since the light sensing film is sensed through the transmitting terminal device 1 emitting light, and the display screen can also emit light itself. In order to avoid lose efficacy of the light sensing film that may happen resulting from an interference between the light emitted by the transmitting terminal device and the light emitted by the display screen. The following three kinds of measures are provided to solve the above problems.

A first measure is: improving an emission intensity of the light emitted by the transmitting terminal device 1, thus, the light sensing film has a greater perceptibility when the light sensing film is irradiated by light.

A second measure is: using a light which spectrum cannot be emitted by the display screen, such as ultraviolet light, and so on.

A third measure is: adding a layer of filter membrane between the light sensing film and the display screen, similar to an ultraviolet light membrane of the glasses, which can reduce the effect of the light emitted by the display screen on the light sensing film.

The receiving terminal device 2 of FIG. 3 is described in detail as the follows.

In detail, referring to FIG. 4, FIG. 4 is a schematic diagram of a receiving terminal device according to an embodiment of present disclosure. The receiving terminal device includes a sensing module 10 and an extracting and calculating module 20.

The sensing module 10 is configured to sense, by means of a light sensing film covered on a display screen of a receiving terminal device, a light beam spot formed on the light sensing film by a light beam that is emitting by a transmitting terminal device.

In detail, the light beam spot formed on the light sensing film by a light beam emitted by a transmitting terminal device is sensed by the sensing module 10. The light beam emitted by the transmitting terminal device can be visible light, or invisible light, or a mixed light beam of the visible light and the invisible light. The light beam emitted by the transmitting terminal device can be light which can not be emitted by the display screen, such as ultraviolet light.

The extracting and calculating module 20 is configured to extract position parameters of the light beam spot on the light sensing film, which are sensed by the light sensing film, and calculate out position coordinates of the light beam spot based on the position coordinates.

In detail, the position parameters of the light beam spot on the light sensing film is extract by the extracting and calculating module 20. The sensing film includes a conductive layer, a resistive layer having uniform resistance, and a photoconductive layer with a photosensitive characteristic. In other words, the light sensing film includes three layers, and the three layers are a first layer, a second layer, and a third layer. The first layer is the resistive layer with uniform resistance, the resistance value of the first layer is constant and even-distributed. The second layer is the photoconductive layer with a photosensitive characteristic, and the characteristic of the second layer is that the resistance value of the second layer is great when there is no light beam, but the resistance value of the second layer drops rapidly falls to small once there is a light beam irradiating on the second layer. The third layer is the conductive layer whose resistance value is very small and can be almost omitted. When the photoconductive layer is irradiated by the light beam, the photoconductive layer is connected to the resistive layer and the conductive layer to let the light sensing film sense the position of light beam spot. The receiving terminal device extracts the position parameters of the light beam spot on the light sensing film according to the resistance value of the resistive layer. For example, when a light beam irradiates from a certain point of the first layer, supposing that the point where the light beam irradiates into on the first layer is a point A, and assuming that the point where the light beam irradiates in on the second layer is a point B, because the resistance value of the second layer drops rapidly to very small when the second layer is irradiated by the light beam, so that the resistance value of the point B drops rapidly to very small, which is almost equivalent that the point A of the first layer conducts with the third layer through the point B with a very small resistance value of the second layer. At this point, the extracting and calculating module 20 extracts the resistance value of the point A, in other words, the extracting and calculating module 20 extracts the position parameters of the light beam spot on the light sensing film, and then the receiving terminal device calculates out the position coordinates of the light beam spot according to the position parameters in order to let the receiving terminal device position the interface elements according to the position coordinates.

The receiving terminal device further includes a receiving module and a performing module.

The receiving module is configured to receive keystroke information transmitted by the transmitting terminal device.

In detail, the receiving terminal device can receives the keystroke information transmitted by the transmitting terminal device through the infrared or other wireless manners.

The performing module is configured to perform operations of the light beam spot on the position coordinates of the light beam spot according to the keystroke information and the position coordinates.

In detail, when the receiving module receives the keystroke information, then the performing module performs a series of operations of the light beam spot corresponding to the interface elements on the position coordinates. For example, when a light beam spot of the light beam moves to a HTTP webpage link, the receiving terminal device obtains the position of the light beam spot through the light sensing film. When the button of the remote control is operated, the terminal such as a television is controlled to perform an operation of opening the webpage link on the position of the light beam spot.

The extracting and calculating module 20 of FIG. 4 is described in detail as follows.

In detail, referring to FIG. 5, FIG. 5 is a schematic diagram of the extracting and calculating module of FIG. 4 according to an embodiment of present disclosure. The extracting and calculating module 20 includes an extracting sub-module 201 and a calculating sub-module 202.

The extracting sub-module 201 is configured to extract a horizontal axis resistance value of the light beam spot and a vertical axis resistance value of the light beam spot of the light beam spot on the light sensing film sensed by the light sensing film.

In detail, the light sensing film includes a conductive layer, a resistive layer having uniform resistance, and a photoconductive layer with a photosensitive characteristic. In other words, the light sensing film includes three layers, and the three layers are a first layer, a second layer, and a third layer. The first layer is the resistive layer with uniform resistance, the resistance value of the first layer is constant and even-distributed. The second layer is the photoconductive layer with a photosensitive characteristic, and the characteristic of the second layer is that the resistance value of the second layer is great when there is no light beam, but the resistance value of the second layer drops rapidly to small once there is a light beam irradiating on the second layer. The third layer is a conductive layer whose resistance value is very small and can be almost omitted. When the photoconductive layer is irradiated by the light beam, the photoconductive layer is connected to the resistive layer and the conductive layer to let the light sensing film sense the position of light beam spot. The receiving terminal device extracts the position parameters of the light beam spot on the light sensing film according to the resistance value of the resistive layer. For example, when a light beam irradiates into a certain point of the first layer, supposing that the point where the light beam irradiated into the first layer is a point A, and assuming that the point where the light beam irradiated in on the second layer is a point B, because the resistance value of the second layer drops rapidly to very small when the second layer is irradiated by the light beam, so that the resistance value of the point B drops rapidly to very small, which is almost equivalent that the point A of the first layer conducts with the third layer through the point B. At this point, the receiving terminal device extracts the resistance value of the point A, in other words, the extracting sub-module 201 extracts the horizontal axis resistance value of the light beam spot and the vertical axis resistance value of the light beam spot.

The calculating sub-module 202 is configured to calculate out a position coordinate of the light beam spot relative to the light sensing film according to the horizontal axis resistance value of the light beam spot and the vertical axis resistance value of the light beam spot of the light beam spot.

The calculating sub-module 202 of FIG. 5 is described in detail as follows.

In detail, referring to FIG. 6, FIG. 6 is a schematic diagram of the calculating sub-module of FIG. 5 according to an embodiment of present disclosure. The calculating sub-module 202 includes a preset sub-module 2021, a horizontal axis coordinate calculating sub-module 2022, and a vertical axis coordinate calculating sub-module 2023.

The preset sub-module 2021 is configured to preset a full screen horizontal axis resistance value of the light sensing film, a full screen vertical axis resistance value of the light sensing film, a horizontal axis length of the light sensing film, and a vertical axis length of the light sensing film.

In detail, the full screen horizontal axis resistance value of the light sensing film, the full screen vertical axis resistance value of the light sensing film, the horizontal axis length of the light sensing film, and the vertical axis length of the light sensing film are preset by the presetting sub-module 2021. Each of the four sides of the first layer of the light sensing film has an electrode. The full screen horizontal axis resistance value is a resistance value between the left side electrode and the right side electrode of the first layer of the light sensing film, and the full screen horizontal axis resistance value is set to be R1. The full screen vertical axis resistance value is a resistance value between the top side electrode and the bottom side electrode of the first layer of the light sensing film, and the full screen vertical axis resistance value is set to be R2. The horizontal axis length of the light sensing film is set to be X, and the vertical axis length of the light sensing film is set to be Y.

The horizontal axis coordinate calculating sub-module 2022 is configured to obtain a horizontal axis coordinate of the light beam spot by calculating out a ratio of the horizontal axis resistance value of the light beam spot and the full screen horizontal axis resistance value, and multiplying the ratio by the horizontal axis length of he light sensing film.

In detail, the horizontal axis coordinate of the light beam spot is calculated by calculating out the ratio of the horizontal axis resistance value of the light beam spot and the full screen horizontal axis resistance value, and multiplying the ratio by the horizontal axis length of the light sensing film. Assuming the light beam spot is P, when the light sensing film is irradiated by light, the light beam spot P is connected to the electrodes of the third layer. The horizontal axis resistance value of the light beam spot and the vertical axis resistance value of the light beam spot of the light beam spot P which is between the electrode of the first layer and the electrode of the third layer are calculated out by the receiving terminal device. Assuming the horizontal axis resistance value of the light beam spot is R3, and the horizontal axis coordinate of the light beam spot P is Xp, and the horizontal axis coordinate Xp is calculated according to a formula 1 as follows.

$$Xp=X*(R3/R1)$$

The vertical axis coordinate calculating sub-module 2023 is configured to obtain a vertical axis coordinate of the light beam spot by calculating out a ratio of the vertical resistance value of the light beam spot and the full screen vertical axis resistance value, and multiplying the ratio by the vertical axis length of the light sensing film.

In detail, the vertical axis coordinate of the light beam spot is obtained by calculating out the ratio of the vertical resistance value of the light beam spot and the full screen vertical axis resistance value, and is multiplied the ratio by the vertical axis length of the light sensing film by the vertical axis coordinate calculating sub-module 2023. Assuming the vertical axis resistance value of the light beam spot is R4, the vertical axis coordinate of the light beam spot P is Yp, the vertical axis coordinate Yp, and the vertical axis coordinate Yp is calculated according to a formula 2 as follows.

$$Yp=Y*(R4/R2)$$

The interface elements which need to be operated are accurately positioned by accurately calculating the position coordinates of the light beam spot.

In the embodiment of present disclosure, the light beam is emitted by the transmitting terminal device, the light beam spot formed on the light sensing film by the light beam is sensed by the light sensing film; the position parameters of the light beam spot on the light sensing film are extracted, and the position coordinates of the light beam spot are figured out according to the position parameters. The light beam spot points to the interface elements which are need to be operated, therefore, an accurate remote control operation to the interface elements is realized for the user, and the user experience of the user is improved.

A person having ordinary skills in the art can realize that part or whole of the processes in the methods according to the above embodiments may be implemented by a computer program instructing relevant hardware. The program may be stored in a computer readable storage medium. When executed, the program may execute processes in the above-mentioned embodiments of methods. The storage medium may be a magnetic disk, an optical disk, a Read-Only Memory (ROM), a Random Access Memory (RAM), et al.

Although certain embodiments of the present disclosure have been specifically described, the present disclosure is not to be construed as being limited thereto. Various changes or modifications may be made to the present disclosure without departing from the scope and spirit of the present disclosure.

**Claims**

1. A method for light remote control positioning, comprising:

   sensing, by means of a light sensing film covered on a display screen of a receiving terminal device, a light beam spot formed on the light sensing film by a light beam that is emitting by a transmitting terminal device; and extracting position parameters of the light beam spot on the light sensing film, which are sensed by the light sensing film, and calculating out position coordinates of the light beam spot based on the position coordinates.

2. The method for light remote control positioning according to claim 1, wherein the step of extracting position parameters of the light beam spot on the light sensing film, which are sensed by the light sensing film, and calculating out position coordinates of the light beam spot based on the position coordinates, comprises:

extracting a horizontal axis resistance value and a vertical axis resistance value of the light beam spot on the light sensing film sensed by the light sensing film; and
calculating out a position coordinate of the light beam spot relative to the light sensing film according to the horizontal axis resistance value of the light beam spot and the vertical axis resistance value of the light beam spot of the light beam spot.

3. The method for light remote control positioning according to claim 2, wherein the step of calculating out a position coordinate of the light beam spot relative to the light sensing film according to the horizontal axis resistance value of the light beam spot and the vertical axis resistance value of the light beam spot of the light beam spot comprises:

presetting a full screen horizontal axis resistance value and a full screen vertical axis resistance value of the light sensing film, and a horizontal axis length and a vertical axis length of the light sensing film;
calculating out the ratio of the horizontal axis resistance value of the light beam spot to the full screen horizontal axis resistance value and obtaining a horizontal axis coordinate of the light beam spot by multiplying the ratio by the horizontal axis length of the light sensing film; and
calculating out the ratio of the vertical axis resistance value of the light beam spot to the full screen vertical axis resistance value, and obtaining a vertical axis coordinate of the light beam spot by multiplying the ratio by the vertical axis length of the light sensing film.

4. The method for light remote control positioning according to claim 3, wherein after the step of extracting a horizontal axis resistance value of the light beam spot and a vertical axis resistance value of the light beam spot of the light beam spot on the light sensing film sensed by the light sensing film, the method further comprises:

receiving keystroke information transmitted by the transmitting terminal device; and
performing operations of the light beam spot on the position coordinates according to the keystroke information and the position coordinates.

5. The method for light remote control positioning according to claim 4, wherein the light sensing film comprises three layers: a first layer, a second layer and a third layer, the first layer is a resistive layer with uniform resistance, the second layer is a photoconductive layer with a photosensitive characteristic, and the third layer is a conductive layer, when the photoconductive layer is irradiated by the light beam, the photoconductive layer is connected to the resistive layer and the conductive layer to let the light sensing film sense the position of light beam spot, the receiving terminal device extracts the position parameters of the light beam spot on the light sensing film according to the resistance value of the resistive layer.

6. The method for light remote control positioning according to claim 5, wherein when the light beam emitted by a transmitting terminal device is the visible light, the light sensing film directly senses a position on which the light beam spot formed by the visible light is projected on the light sensing film.

7. The method for light remote control positioning according to claim 5, wherein when the light beam emitted by a transmitting terminal device is the invisible light, a display screen generates a cursor pattern on the position on which the light beam of the invisible light is projected on the light sensing film.

8. The method for light remote control positioning according to claim 5, wherein when the light beam emitted by a transmitting terminal device is the mixed light beam of visible light and invisible light, the light sensing film directly senses a position on which the light beam spot formed by the mixed light beam spot is projected on the light sensing film.

9. A device for light remote control positioning, comprising:

a sensing module configured to sense, by means of a light sensing film covered on a display screen of a receiving terminal device, a light beam spot formed on the light sensing film by a light beam that is emitting by a transmitting terminal device; and
an extracting and calculating module configured to extract position parameters of the light beam spot on the light sensing film, which are sensed by the light sensing film, and calculate out position coordinates of the light

11

beam spot based on the position coordinates.

10. The device for light remote control positioning according to claim 9, wherein the extracting and calculating module, comprises:

> an extracting sub-module configured to extract a horizontal axis resistance value of the light beam spot and a vertical axis resistance value of the light beam spot of the light beam spot on the light sensing film sensed by the light sensing film; and
> a calculating sub-module configured to calculate out a position coordinate of the light beam spot relative to the light sensing film according to the horizontal axis resistance value of the light beam spot and the vertical axis resistance value of the light beam spot of the light beam spot.

11. The device for light remote control positioning according to claim 10, wherein the calculating sub-module, comprises:

> a preset sub-module configured to preset a full screen horizontal axis resistance value of the light sensing film, a full screen vertical axis resistance value of the light sensing film, a horizontal axis length of the light sensing film, and a vertical axis length of the light sensing film;
> a horizontal axis coordinate calculating sub-module configured to obtain a horizontal axis coordinate of the light beam spot by calculating out a ratio of the horizontal axis resistance value of the light beam spot and the full screen horizontal axis resistance value, and multiplying the ratio by the horizontal axis length of he light sensing film; and
> a vertical axis coordinate calculating sub-module configured to obtain a vertical axis coordinate of the light beam spot by calculating out a ratio of the vertical resistance value of the light beam spot and the full screen vertical axis resistance value, and multiplying the ratio by the vertical axis length of the light sensing film.

12. The device for light remote control positioning according to claim 11, further comprising:

> a receiving module configured to receive keystroke information transmitted by the transmitting terminal device; and
> a performing module is configured to perform operations of the light beam spot on the position coordinates of the light beam spot according to the keystroke information and the position coordinates.

13. The device for light remote control positioning according to claim 12, wherein the light sensing film comprises three layers: a first layer, a second layer and a third layer, the first layer is a resistive layer with uniform resistance, and the second layer is a photoconductive layer with a photosensitive characteristic, and the third layer is a conductive layer, when the photoconductive layer is irradiated by the light beam, the photoconductive layer is connected the resistive layer and the conductive layer to let the light sensing film sense the position of light beam spot, the receiving terminal device extracts the position parameters of the light beam spot on the light sensing film according to the resistance value of the resistive layer.

14. The device for light remote control positioning according to claim 13, wherein when the light beam emitted by a transmitting terminal device is visible light, the light sensing film directly senses the light beam spot formed by the visible light on the light sensing film.

15. The device for light remote control positioning according to claim 13, wherein when the light beam emitted by a transmitting terminal device is the invisible light, a display screen generates a cursor pattern on the position on which the light beam of the invisible light is projected on the light sensing film.

16. The device for light remote control positioning according to claim 13, wherein when the light beam emitted by a transmitting terminal device is the mixed light beam of visible light and invisible light, the light sensing film directly senses a position on which the light beam spot formed by the mixed light beam spot is projected on the light sensing film.

17. A system for light remote control positioning, comprising:

> a transmitting terminal device and a receiving terminal device;
> the transmitting terminal device configured to transmit light beam to a display screen of the receiving terminal device to form a light beam spot, and transmit keystroke information to the receiving terminal device when a

EP 2 908 214 A1

button is operated; and
the receiving terminal device comprising a device for light remote control positioning of any claim of claim 9 to claim 16.

Sensing, by means of a light sensing film covered on a display screen of a receiving terminal device, a light beam spot formed on the light sensing film by a light beam that is emitting by a transmitting terminal device — S101

Extracting position parameters of the light beam spot on the light sensing film, which are sensed by the light sensing film, and calculating out a position coordinates of the light beam spot based on the position coordinates — S102

**FIG. 1**

Sensing, by means of a light sensing film covered on a display screen of a receiving terminal device, a light beam spot formed on the light sensing film by a light beam that is emitting by a transmitting terminal device — S201

Extracting a horizontal axis resistance value and a vertical axis resistance value of the light beam spot on the light sensing film sensed by the light sensing film — S202

Presetting a full screen horizontal axis resistance value and a full screen vertical axis resistance value of the light sensing film, and a horizontal axis length and a vertical axis length of the light sensing film — S203

Calculating out the ratio of the horizontal axis resistance value of the light beam spot to the full screen horizontal axis resistance value and obtaining a horizontal axis coordinate of the light beam spot by multiplying the ratio by the horizontal axis length of the light sensing film — S204

Calculating out the ratio of the vertical axis resistance value of the light beam spot to the full screen vertical axis resistance value, and obtaining a vertical axis coordinate of the light beam spot by multiplying the ratio by the vertical axis length of the light sensing film — S205

Receiving keystroke information transmitted by the transmitting terminal device — S206

Performing operations of the light beam spot on the position coordinates according to the keystroke information and the position coordinates — S207

**FIG. 2**

1

2

| Transmitting terminal device | Receiving terminal device |

System for light remote control positioning

**FIG. 3**

2

10

20

| Sensing module | Extracting and calculating module |

Receiving terminal device

**FIG. 4**

20

201

202

| Extracting sub-module | Calculating sub-module |

Extracting and calculating module

**FIG. 5**

202

2021

2022

2023

| Preset sub-module | Horizontal coordinate calculating sub-module | Vertical coordinate calculating sub-module |

Calculating sub-module

**FIG.6**

# INTERNATIONAL SEARCH REPORT

| International application No. |
|---|
| PCT/CN2012/086007 |

### A. CLASSIFICATION OF SUBJECT MATTER

See the extra sheet
According to International Patent Classification (IPC) or to both national classification and IPC

### B. FIELDS SEARCHED

Minimum documentation searched (classification system followed by classification symbols)

IPC: G06F

Documentation searched other than minimum documentation to the extent that such documents are included in the fields searched

Electronic data base consulted during the international search (name of data base and, where practicable, search terms used)

CNABS, CNTXT, CNKI, VEN: ray, light, beam, remote, display screen, sensing film, position, resistance, coordinate, ordinate, abscissa, transverse, longitudinal

### C. DOCUMENTS CONSIDERED TO BE RELEVANT

| Category* | Citation of document, with indication, where appropriate, of the relevant passages | Relevant to claim No. |
|---|---|---|
| X | CN 101593067 A (HONGFUJIN PRECISION IND SHENZHEN CO LTD et al.) 02 December 2009 (02.12.2009) see description, page1, the last paragraph to page 2, the last paragraph and figures 2 to 4 | 1, 9, 17 |
| Y | | 2-8,10-16 |
| Y | CN 102033665 A (HANDAN CHUANGXUN INFORMATION TECHNOLOGY ENG CO LTD) 27 April 2011 (27.04.2011) see description, paragraphs [0025] to [0029] | 2-8, 10-16 |
| X | CN 101751188 A (SHANTOU GOWORLD DISPLAY CO) 23 June 2010 (23.06.2010) see description, paragraphs [0053] to [0074] and figure 1 | 1, 9, 17 |
| A | CN 101989151 A (ZHIDIAN TECHNOLOGY SHENZHEN CO LTD) 23 March 2011 (23.03.2011) see the whole document | 1-17 |
| A | CN 101477427 A (WEI, Ming) 08 July 2009 (08.07.2009) see the whole document | 1-17 |

☒ Further documents are listed in the continuation of Box C.　　　☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 26 June 2013 (26.06.2013) | 25 July 2013 (25.07.2013) |
| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>WU, Juan<br><br>Telephone No. (86-10) 62084090 |

Form PCT/ISA /210 (second sheet) (July 2009)

## INTERNATIONAL SEARCH REPORT

International application No.

PCT/CN2012/086007

C (Continuation).    DOCUMENTS CONSIDERED TO BE RELEVANT

| Category* | Citation of document, with indication, where appropriate, of the relevant passages | Relevant to claim No. |
|---|---|---|
| A | CN 102279656 A (3DIJOY SHANGHAI CORP et al.) 14 December 2011 (14.12.2011) see the whole document | 1-17 |
| A | JP 2006011569 A (CITIZEN SEIMITSU CO LTD) 12 January 2006 (12.01.2006) see the whole document | 1-17 |

Form PCT/ISA /210 (continuation of second sheet) (July 2009)

## INTERNATIONAL SEARCH REPORT
### Information on patent family members

| | International application No. |
|---|---|
| | PCT/CN2012/086007 |

| Patent Documents referred in the Report | Publication Date | Patent Family | Publication Date |
|---|---|---|---|
| CN 101593067 A | 02.12.2009 | CN 101593067 B | 20.06.2012 |
| | | US 2009295761 A1 | 03.12.2009 |
| CN 102033665 A | 27.04.2011 | None | |
| CN 101751188 A | 23.06.2010 | CN 101751188 B | 25.04.2012 |
| CN 101989151 A | 23.03.2011 | None | |
| CN 101477427 A | 08.07.2009 | None | |
| CN 102279656 A | 14.12.2011 | None | |
| JP 2006011569 A | 12.01.2006 | None | |

Form PCT/ISA /210 (patent family annex) (July 2009)

## **INTERNATIONAL SEARCH REPORT**

International application No.

PCT/CN2012/086007

Continuation of second sheet    A. CLASSIFICATION OF SUBJECT MATTER

G06F 3/01 (2006.01) i

G06F 3/042 (2006.01) i

Form PCT/ISA /210 (extra sheet) (July 2009)